# EUROPEAN PATENT APPLICATION

(11) **EP 2 085 892 A1**
(43) Date of publication of application: **05.08.2009**
(21) Application number: 09001331.9
(22) Date of filing: 30.01.2009
(51) Int. Cl.: G06F 15/78, H03K 19/177

(54) **Processing circuit**

(30) Priority: 31.01.2008 JP 2008022064
(71) Applicant: SANYO Electric Co., Ltd., Moriguchi-shi Osaka 570-8677 (JP)
(72) Inventor: Iizuka, Kazuhisa, Osaka 570-8677 (JP); Ozone, Makoto, Osaka 570-8677 (JP)
(74) Representative: Glawe, Delfs, Moll

(57) **Abstract**

A processing circuit according to the present invention includes a plurality of logic circuits (designated as L11, ..., and L44) formed by arranging in arrays and is configured to input an output from a logic circuit to the logic circuit located on the following row. Each of the plurality of logic circuits includes an operation circuit (ALU) configured to perform an operation on inputted data; and a selecting unit (MUX) configured to select and output any one of an operation output from the operation circuit or an operation output from the logic circuit located on the preceding row.

## Description

### CROSS REFERENCE TO RELATED APPLICATIONS

This application is based upon and claims the benefit of priority from prior Japanese Patent Application No. 2008-022064, filed on January 31, 2008, the entire contents of which are incorporated herein by reference.

### BACKGROUND OF THE INVENTION

### 1. Field of the Invention

The present invention relates to a processing circuit using an arithmetic logic unit (ALU) array or the like, and particularly relates to a processing circuit capable of both a single precision operation and a double precision operation.

### 2. Description of the Related Art

The applicant has studied a reconfigurable circuit with an arithmetic logic unit (ALU) array in which multifunctional devices referred to as ALU having multiple basic operation functions are arranged in multiple rows (see, for example, Japanese Patent Application Publication No.2005-182654 and "JOUHOU-KADEN-MUKE KOGATA-RIKONFIGYURABURU-DEBAISU (A Compact Reconfigurable Device for Information Appliances)," Sanyo Electric Co., Ltd., Engineering Report Vol. 37, No.2, March 2006, Serial No. 77). This reconfigurable circuit functions as a desired processing circuit with configuration information being set in each ALU. Specifically, the configuration information includes an instruction set that controls functions of the ALUs and a connection data set that controls a connection destination between the ALUs.

The reconfigurable circuit with the ALU array has advantages that mounting size can be made smaller than a reconfigurable circuit with field programmable gate array (FPGA), and that reconfiguration of a circuit can be performed rapidly. Thus, processing circuits capable of performing a wide variety of processing or compatible with various standards can be performed in a single LSI. Additionally, the reconfigurable circuit with the ALU array can immediately be made compatible with a new standard by updating the software.

When various processing circuits are performed by using the reconfigurable circuit as described above, some processings may require multiple-bit operations may be required in which the number of usable operation bits exceeds that of an ALU in the reconfigurable circuit. For example, there may arise a need to perform a 32-bit operation when the operation bit width of the ALU in the reconfigurable circuit is 16 bits. Namely, a so-called double precision operation may be required.

Meanwhile, some processings may only require an operation that only requires operation bits that can be handled by the ALU in the reconfigurable circuit. Namely, a single precision operation may be sufficient. For example, there is a case in which a 16-bits operation is sufficient when the operation bit width of the ALU in the reconfigurable circuit is 16 bits.

Thus, it has been expected that a reconfigurable circuit can perform both a single precision operation and a double precision operation.

### SUMMARY OF THE INVENTION

An aspect of the present invention is summarized as a processing circuit, including a plurality of logic circuits and configured to input an operation output from a first logic circuit into a second logic circuit. The second logic circuit includes: an operation circuit configured to perform an operation on inputted data; and a selecting unit configured to select and output any one of an operation output from the operation circuit or an operation output from the first logic circuit. Here, the "operation" may be an operation such as a shift operation, in addition to an adding operation, a subtracting operation.

The selecting unit may select and output the operation output from the operation circuit when the second logic circuit performs a single precision operation. Further, the selecting unit may select and output the operation output from the first logic circuit when the second logic circuit performs a multiple precision operation.

Here, the multiple precision operation includes, in addition to so-called double precision operation, an N-times-precision operation. Incidentally, N denotes a natural number not smaller than 3.

The plurality of logic circuits may be arranged in a matrix, in a row direction and in a column direction.

In such case, the first logic circuit and the second logic circuit may be located on two successive rows, respectively. Further, the operation output from the selecting unit may be inputted to a part of following logic circuits located on a row following logic circuit.

Additionally, each of the plurality of logic circuit may includes at least: a first type logic circuit arranged in a predetermined row and configured to perform a single precision operation or an operation of lower-order digits in a multiple precision operation, and a second type logic circuit arranged in a row following the predetermined row, and configured to perform an operation of the single precision operation or an operation of higher-order digits in the multiple precision operation.

Note that, in the "plurality of logic circuits", the first logic circuit and the second logic circuit may be the same circuits. Accordingly, the operation output from the first logic circuit may be used as the input to the first logic circuit.

A processing circuit having different configuration in the present invention is summarized as a processing circuit including a plurality of logic circuits arranged in a column direction and configured to operate in accordance with set data supplied periodically in a predetermined time from an outside. Each of the plurality of logic circuits includes: an operation circuit configured to perform an operation on inputted data; a state holding circuit configured to store an operation output from the operation circuit for the predetermined time; and a selecting unit configured to select any one of an operation output from the operation circuit and the operation output held in the state holding circuit. The processing circuit in this aspect further includes a connecting unit configured to input an output from the selecting unit into a part of the plurality of logic circuits.

A processing circuit having another different configuration in the present invention is summarized as a processing circuit including a logic circuit configured to operate in accordance with set data supplied periodically in a predetermined time from an outside. The logic circuits includes: an operation circuit configured to perform an operation on inputted data; a state holding circuit configured to hold an operation output from the operation circuit for the predetermined time; and a selecting unit configured to select any one of an operation output from the operation circuit and the operation output held in the state holding circuit. The processing circuit in this aspect further includes a connecting unit configured to input an output from the selecting unit into the logic circuit.

### BRIEF DESCRIPTION OF THE DRAWINGS

- Fig. 1: is a view showing configurations of a processing apparatus 10 and a set data generating apparatus 30, respectively, according to this embodiment.
- Fig. 2: is a view showing a configuration of a reconfigurable circuit 12.
- Fig. 3: is a view describing an example of performing a double precision operation by use of the reconfigurable circuit 12.
- Fig. 4: is a view describing an example of performing a single precision operation by use of the reconfigurable circuit 12.
- Fig. 5: is a view showing an internal configuration of an ALU in each logic circuit of the reconfigurable circuit 12.
- Fig. 6: is a view showing a configuration of a reconfigurable circuit 12A.
- Fig. 7: is a view showing a configuration of a reconfigurable circuit 12B.
- Fig. 8: is a view showing an example of performing a triple precision operation by use of the reconfigurable circuit 12B.
- Fig. 9: is a view showing an example of performing a double precision operation by use of the reconfigurable circuit 12B.
- Fig. 10: is a view showing an example of performing a single precision operation by use of the reconfigurable circuit 12B.
- Fig. 11: is a view showing a configuration of a reconfigurable circuit 12C.
- Fig. 12: is a view showing an example of performing a triple precision operation by use of the reconfigurable circuit 12C.
- Fig. 13: is a view showing an example of performing a double precision operation by use of the reconfigurable circuit 12C.
- Fig. 14: is a view showing an example of performing a single precision operation by use of the reconfigurable circuit 12C.
- Fig. 15: is a view showing a configuration of a reconfigurable circuit 12D.
- Fig. 16: is a configuration diagram of an ALU in a logic circuit in the reconfigurable circuit 12D.
- Fig. 17: is a view showing an example of performing a double precision operation by use of the reconfigurable circuit 12D.
- Fig. 18: is a view showing an example of performing a single precision operation by use of the reconfigurable circuit 12D.
- Fig. 19: is a view showing a configuration of a reconfigurable circuit 12E.
- Fig. 20: is a view showing a configuration of a logic circuit to be arranged in an odd-numbered row of the reconfigurable circuit 12E.
- Fig. 21: is a view showing an example of performing a double precision operation by use of the reconfigurable circuit 12E.
- Fig. 22: is a view showing a configuration of a reconfigurable circuit 12F.
- Fig. 23: is a view showing an example of operations by use of the reconfigurable circuit 12F.

### DESCRIPTION OF THE PREFERRED EMBODIMENTS

### [First Embodiment]

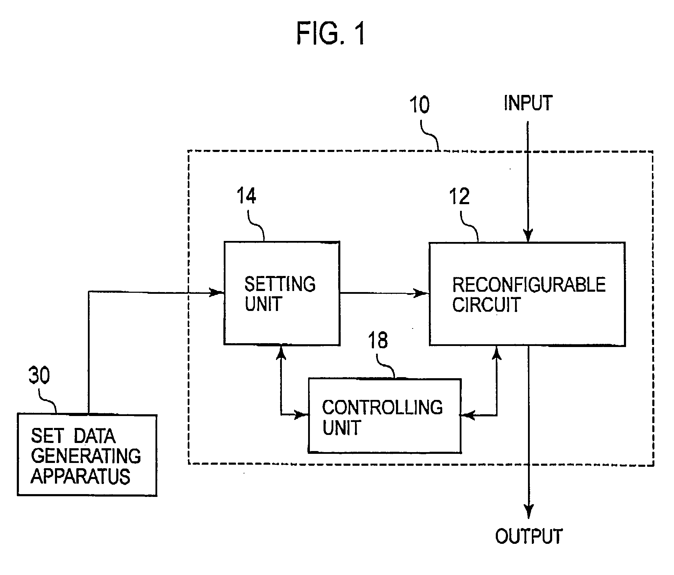

Fig. 1 is a view showing configurations of a processing apparatus 10 and a set data generating apparatus 30, respectively, according to an embodiment.

### (Configuration of the processing apparatus 10)

The processing apparatus 10 is formed of an integrated circuit that is configured as one chip, and includes a reconfigurable circuit 12, a setting unit 14, and a controlling unit 18.

The reconfigurable circuit 12 has a structure including multiple logic circuits configured by ALUs whose functions can be changed. The reconfigurable circuit 12 functions as an operation circuit that operates in accordance with set data supplied from the setting unit 14, to be described later. Specifically, the reconfigurable circuit 12 performs operations in accordance with the set data, on the data inputted from an external device, and outputs operation results. The configuration of this reconfigurable circuit 12 will be described later in detail. Note that, this reconfigurable circuit 12 is one example of a processing circuit of the invention of this application.

The setting unit 14 supplies the set data for configuring a desired operation circuit to the reconfigurable circuit 12.

Supplying the set data from the setting unit 14 allows the reconfigurable circuit 12 to be configured as a desired operation circuit. This set data is generated by a set data generating apparatus 30 to be described later.

The controlling unit 18 controls each part of the processing apparatus 10, namely, the reconfigurable circuit 12 and the setting unit 14.

### (Configuration of a set data generating apparatus 30)

The set data generating apparatus 30 analyzes a program in which an operation of the processing to be performed in the reconfigurable circuit 12 is set, and generates set data to be mapped to the reconfigurable circuit 12. This set data defines functions of logic circuits in the reconfigurable circuit 12 and connection relationships among respective logic circuits. Set data generated by the set data generating apparatus 30 is supplied to the reconfigurable circuit 12 via the setting unit 14.

### (Configuration of a reconfigurable circuit 12)

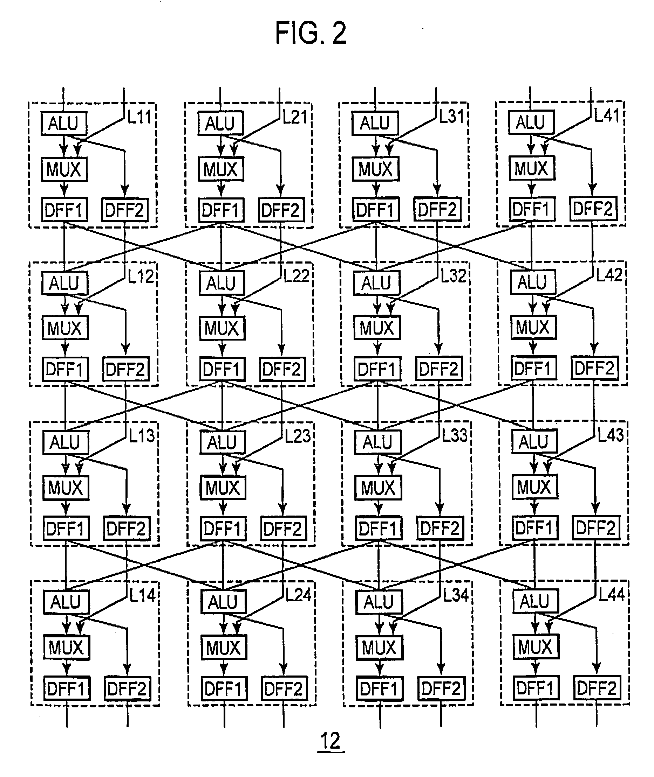

Fig. 2 shows a part of a configuration of the reconfigurable circuit 12.

As shown in Fig. 2, the reconfigurable circuit 12 is formed by arranging a plurality of logic circuits (designated as L11, ..., and L44 in Fig. 2) in arrays. Each of the logic circuits includes an ALU that is an operation circuit, an MUX that is a selecting unit, and a DFF1 and a DFF2 that are D-type flip flops.

In the ALU in each logic circuit, an operation function is set in accordance with the set data. For example, the ALU can function as an adder, a subtractor, a logical OR operator, a logical AND operator, a bit shift operator, or the like.

In each logic circuit, an operation result in the ALU is outputted to the MUX. The data outputted to the MUX is inputted to the ALU of a logic circuit in the following row via the DFF1. In addition, the operation result of each ALU is outputted to the MUX in a logic circuit in the following row of the same column (such data outputted to a logic circuit in the following row via the DFF2 will be referred to as "delayed output data" hereinafter). For example, the operation result in the ALU in the logic circuit L11 is outputted to the MUX of the logic circuit L12 via the DFF2 of the L11 as well as the MUX of the L11. The MUX selects data from output data from the ALU in the same logic circuit and output data from the ALU in the logic circuit located on the preceding row and then outputs the selected data. For example, the MUX in the logic circuit L12 selects data from output from the ALU in the L12 and output from the ALU in the L11, and then outputs the selected data.

Note that, in the reconfigurable circuit 12, output data from DFF1 in each logic circuit is inputted to only three logic circuits respectively located on the same, right and left columns of the following row. Specifically, the reconfigurable circuit is configured to have so-called "connection limit" in which connection destinations of outputs from logic circuits are limited in order to make the circuit size smaller. In addition, delayed output is configured to be inputted to a logic circuit in the following row of the same column.

Although Fig. 2 shows an example consisted of 16 logic circuits so as to simplify the description of the configuration of the reconfigurable circuit 12, it is obvious that the present invention is not limited to this. The logic circuit may be formed as multiple logic circuits, such as tens of, hundreds of, or more logic circuits. Similarly, the number of the logic circuit may be less than 16.

### (Example of a double precision operation by use of the reconfigurable circuit 12)

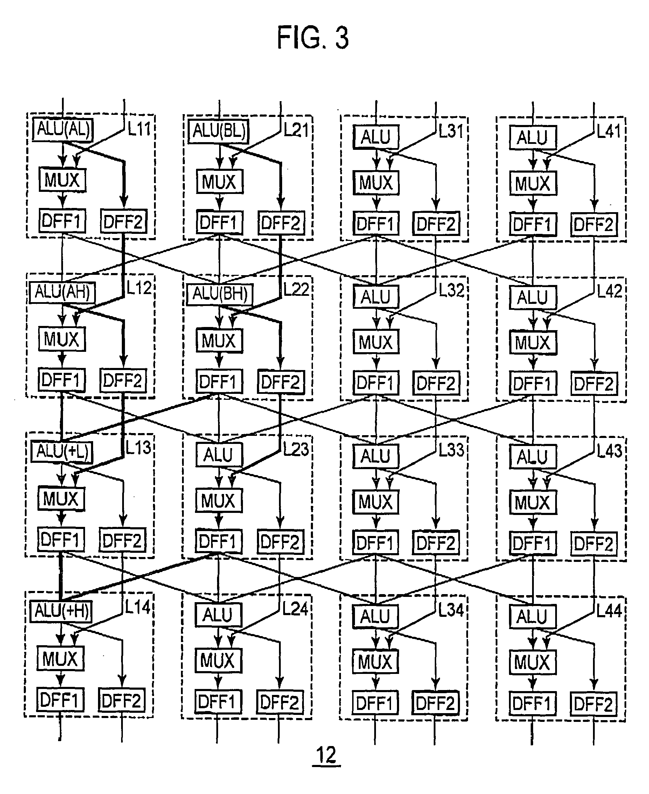

An example of performing a double precision operation by use of the reconfigurable circuit 12 will be described with reference to Fig. 3. Here, on the assumption that the operation bit width of the ALU in each logic circuit of the reconfigurable circuit 12 is 16 bits, a description will be given for an example in which addition of 32-bits variables A+B is performed. Where higher 16 bits of the 32-bits variable A are AH, lower 16 bits of the 32-bits variable A are AL, higher 16 bits of the 32-bits variable B are BH, and lower 16 bits of the 32-bits variable B are BL, the operation A+B is performed by being divided into the addition AL+BL of the lower-order bits and the addition of the higher-order bits AH+BH. Here, data to be outputted from the ALU in the logic circuit L11 is AL, data to be outputted from the ALU in the logic circuit L12 is AH, data to be outputted from the ALU in the logic circuit L21 is BL, and data to be outputted from the ALU in the logic circuit L22 is BH.

First, an operation of the lower-order bits will be described. The AL outputted from the ALU in the logic circuit L11 is inputted to the MUX in the logic circuit L12 via the DFF2 in the L11. In this MUX, this AL is selected, outputted to the DFF1 in the L12, and then outputted to the ALU in the L13 via this DFF1.

Meanwhile, the BL outputted from the ALU in the logic circuit L21 is outputted to the MUX in the logic circuit L22 via the DFF2 in the L21. In this MUX, this BL is selected, outputted to the DFF1 in the L22, and then outputted to the ALU in the logic circuit L13 via this DFF1. Subsequently, addition of the AL and the BL is performed in this ALU.

With the configuration as described above, the adding process of the outputs from the ALUs in the logic circuits L11 and L21 that are arranged two rows above can be performed by using the ALU in the logic circuit L13. Specifically, the MUX in the logic circuit L12 located on the preceding row of the same column as the logic circuit L13, which includes the ALU configured to perform the adding process, selects, not the output from the ALU in the same logic circuit L12 including the MUX, but the output from the ALU in the logic circuit L11 located on the preceding row of the same column. In addition, the MUX of the logic circuit L22 located on the preceding row of the right column of the logic circuit L13 selects, not the output from the ALU of the logic circuit L22 including the MUX, but the output from the ALU of the logic circuit L21 located on the preceding row of the same column. Thus, the adding process of the logic circuits L11 and L12 arranged two rows above can be performed.

Secondly, an operation of the higher-order bits will be described. The AH outputted from the ALU in the logic circuit L12 is inputted to the MUX in the logic circuit L13 via the DFF2 in the L12. In this MUX, this AH is selected, outputted to the DFF1 in the L13, and then outputted to the ALU in the logic circuit L14 via this DFF1.

Meanwhile, the BH outputted from the ALU in the logic circuit L22 is inputted to the MUX of the logic circuit L23 via the DFF2 in the L22. In this MUX, this BH is selected, outputted to the DFF1 in the L23, and then outputted to the ALU in the logic circuit L14 via this DFF1. Subsequently, in this ALU, the addition of AH+BH is performed.

With the configuration described above, the adding process of the outputs from the ALUs in the logic circuits L12 and L22 arranged two rows above can be performed, by use of the ALU in the logic circuit L14. To be more specific, such the adding process can be performed with the following configuration. The MUX in the logic circuit L13 located on the preceding row of the same column of the logic circuit L14 assigned the ALU configured to perform adding process selects, not the output from the ALU of the same logic circuit L3 including the MUX, but the output from the ALU of the logic circuit L12 in the row preceding of the same column.

As described above, the double precision operation by the reconfigurable circuit 12 can be performed.

Meanwhile, in order to perform a single precision operation, i.e., for an operation performed where the operation bit width of an ALU in each logic circuit of the reconfigurable circuit 12 is equal to the number of bits of variables, MUX may be configured to select not input data from the DFF2 in the logic circuit located on the preceding row but input data from the operation circuit in the logic circuit including the MUX.

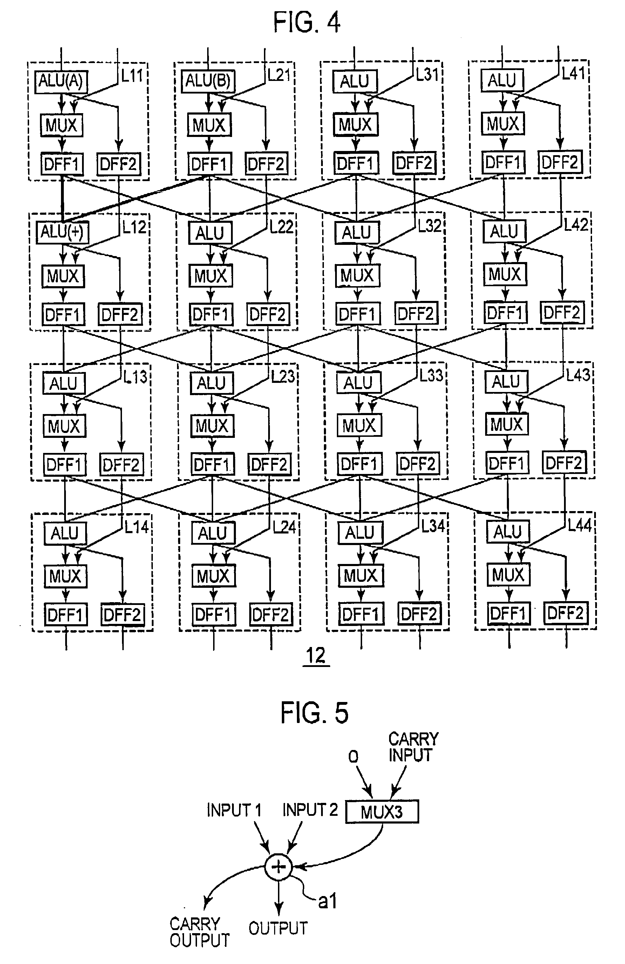

An example of performing a single precision operation by use of the reconfigurable circuit 12 will be described with reference to Fig. 4. Similar to the example of Fig. 3, on the assumption that the operation bit width of the ALU in each logic circuit of the reconfigurable circuit 12 is 16 bits, a description will be given for an example in which an addition of 16-bits variables A+B is performed. Here, data to be outputted from the ALU in the logic circuit L11 is A, while data to be outputted from the ALU in the logic circuit L12 is B.

The MUX in the logic circuit L11 selects the A outputted from the ALU in the logic circuit L11 and outputs the A to the DFF1 in the L11 and then to the ALU in the logic circuit L12 via this DFF1.

On the other hand, the MUX in the logic circuit L21 selects the B outputted from the ALU in the logic circuit L21 and outputs the B to the DFF1 in the L21 and then to the ALU in the logic circuit L12 via this DFF1. Subsequently, in this ALU, addition of A and B is performed.

As described above, the reconfigurable circuit 12 can also perform a single precision operation.

Thus, the reconfigurable circuit 12 can perform both a single precision operation and a double precision operation by switching such selections. In other words, the selecting unit MUX selects and outputs the operation output from the ALU in the logic circuit including the MUX, when a single precision operation is performed, and selects and outputs the operation output from the ALU of the logic circuit located on the preceding row of the same column, when a double precision operation is performed.

The reconfigurable circuit 12 according to this embodiment has a so-called "connection limit. " In such reconfigurable circuit 12, when performing an operation that can be operated by a single precision operation as shown in Fig. 4, a double precision operation can also be performed under the same connection limit by arranging operations doubled in the vertical direction as shown in Fig. 3. Thereby, enhanced efficiency of the double precision can be achieved.

Although not shown in Figs. 2 to 4, a carry to be operated in the ALU configured to add lower-order bits in the logic circuit L13 is inputted to the ALU configured to add higher-order bits in the logic circuit L14. Thus, when the double precision operation is performed, the ALU in the logic circuit L14 adds the carry operated in the ALU in the L13, in addition to the AH and the BH. Thereby, the double precision addition can be accurately performed.

### (Configuration of an operation circuit)

An internal configuration of each ALU of the reconfigurable circuit 12 will be described hereinafter. Fig. 5 shows an internal configuration of an ALU provided in each logic circuit of the reconfigurable circuit 12. Here, a description will be given for an example in which an addition function is assigned to the ALU. In this example, the function of the ALU can be equivalently described by an MUX3 that is a selecting unit and an adder a1. First, an input of a carry from the lower-order bit and 0 (zero) are inputted to the MUX3, which then selects and outputs these into the adder a1. If the ALU is designed to add the least significant bits, the MUX 3 selects and outputs 0. If the ALU is not designed to add the least significant bits, the MUX selects and outputs the input of the carry from the lower-order bit. Inputs 1, 2 and the output from the MUX3 are inputted to the adder a1. Then, the result of these additions and the carry output are outputted. The aforementioned double precision addition can be performed by use of such the operation circuit as an ALU in the logic circuit of the reconfigurable circuit 12.

In addition, operations can be assigned to the reconfigurable circuit 12 so that, for example, lower-order bit operations or single precision operation are performed in odd-numbered rows in the reconfigurable circuit 12. Further, higher-order bit operations or single precision operation can be performed in even-numbered rows. In such case, the selecting unit MUX3 can be omitted because carry input can be fixed to zero in the odd-numbered rows. Thus, reduction of the circuit size of ALUs in respective logic circuits can be achieved, by limiting assignment of ALUs to either lower-order bit operations or higher-order bit operations.

### [Second Embodiment]

### (Configuration of a reconfigurable circuit 12A)

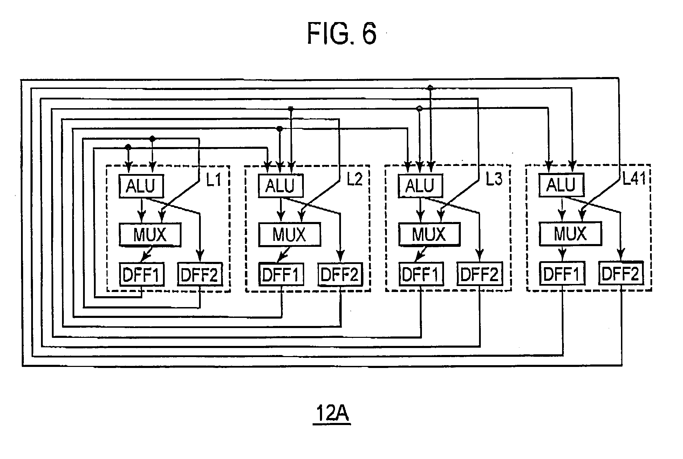

A reconfigurable circuit 12A as shown in Fig. 6 is capable of both of a double precision operation and a single precision operation. This reconfigurable circuit 12A is configured to loop back in a one-row configuration, instead of the four-row configuration of the reconfigurable circuit 12 as shown in Fig. 2. The setting unit 14 (see Fig. 1) supplies set data to the reconfigurable circuit 12A on a predetermined timing. Then, each logic circuit constituting the reconfigurable circuit 12A performs operations in accordance with the set data supplied from this setting unit 14. This reconfigurable circuit 12A can also perform the process of the double precision addition (A+B). The procedure thereof will be described hereinafter.

First, at a first timing, AL is outputted from the ALU in the L1 and BL is outputted from the ALU in the L2. The AL outputted from the ALU of the L1 is outputted to the DFF2 in the L1. The BL outputted from the L2 is outputted to the DFF2 in the L2. The respective DFF2s in the L1 and the L2 store (temporarily store) the AL and the BL, respectively. Specifically, at the first timing, the L1 and the L2 function similarly to the L11 and the L21, respectively, as shown in Fig. 3.

Then, at a second timing, AH is outputted from the ALU in the L1 and BH is outputted from the ALU in the L2. Subsequently, the AL stored in the DFF2 in the L1 is outputted to the MUX in the L1, and the BL stored in the DFF2 is outputted to the MUX in the L2. From the ALU in the L1, the AH is outputted to both the MUX in the L1 and the DFF2. The MUX in the L1 is configured to select the AL from the AH and the AL, and output the AL to the DFF1. Similarly, from the ALU in the L2, the BH is outputted to both the MUX and the DFF2. The MUX in the L2 is configured to select the BL from the BH and the BL, and output the BL to the DFF1. Thus, the AL is stored in the DFF1 in the L1, the AH is stored in the DFF2, the BL is stored in the DFF1 in the L2, and the BH is stored in the DFF2. In other words, at the second timing, the L1 and L2 function similarly to the L12 and the L22, respectively, as shown in Fig. 3.

Next, at a third timing, the add function is set in the ALU in the L1. At this timing, the AH stored in the DFF2 in the L1 is outputted to the MUX in the L1, while the BH stored in the DFF2 in the L2 is outputted to the MUX in the L2. In addition, the AL stored in the DFF1 in the L1 and the BL stored in the DFF1 in the L2 are outputted to the ALU in the L1. From the ALU in the L1, addition result of the AL and the BL is outputted to both the MUX and the DFF2 in the L1. The MUX in the L1 is set to select the AH from among the addition result and the AH, and to output the AH to the DFF1. Further, the MUX in the L2 is set to select the BH from among the two inputs, and to output the BH to the DFF1. In other words, at the third timing, the L1 and the L2 function similarly to the L13 and L23, respectively, as shown in Fig. 3.

Next, at a fourth timing, the add function is set in the ALU in the L1. Then, the AH stored in the DFF1 in the L1 and the BH stored in the DFF1 in the L2 are outputted to the ALU in the L1. The addition result of the AH and the BH is outputted from the ALU in the L1. In other words, at the fourth timing, the L1 and the L2 function similarly to the L14 and L24, respectively, as shown in Fig. 3.

Namely, the reconfigurable circuit 12A according to the second embodiment is configured to loop back in a one-row configuration, and executes a double precision operation by switching the functions of the ALU or the operations of the MUX in accordance with the set data supplied from the setting unit 14.

### [Third Embodiment]

### (Configuration of a reconfigurable circuit 12B)

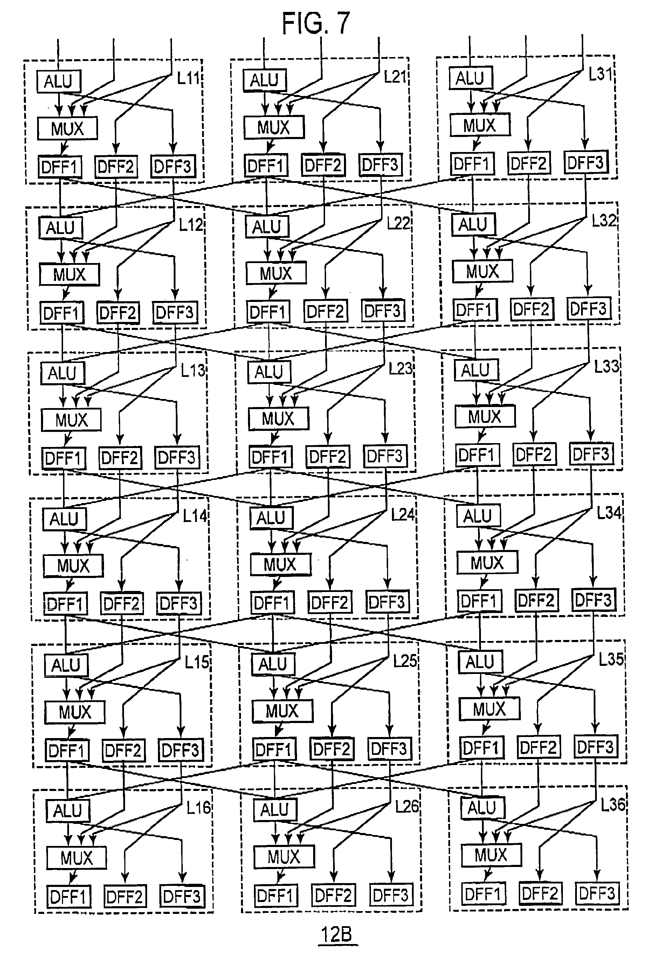

A reconfigurable circuit 12B as shown in Fig. 7 is capable of a triple precision operation, a double precision operation, and a single precision operation. This reconfigurable circuit 12B is formed by arranging a plurality of logic circuits (designated as L11, ..., L16, L21.... , L26, L31.... in Fig. 7) in arrays. Each of the logic circuits includes the ALU that is an operation circuit, an MUX that is a selecting unit, and DFF1, DFF2, and DFF3 that are D-type flip flops.

In each logic circuit, output from the ALU is outputted to the MUX and the DFF3. Output from the DFF3 is outputted to the MUX and the DFF2 located on the following row of the same column. For example, output from the DFF3 in the L11 is outputted to the MUX and the DFF2 in the L12.

The MUX in the each logic circuit selects any one of three inputs, namely, output from the ALU in the logic circuit including the MUX, output from the DFF2 in the logic circuit located on the preceding row, and output from the DFF3 in the logic circuit located on the preceding row, and then outputs the selected one to the DFF1 in the logic circuit including the MUX. For example, the MUX in the L13 selects any one of the ALU in the L13, the DFF2 in the L12, and the DFF3 in the L12, and then outputs the selected one to the DFF1 in the L13. Here, the output from the ALU in the L11 has been inputted to the DFF2 in the L12 via the DFF3 in the L11. Thus, selection of input from the DFF2 in the L12 by the MUX in the L13 corresponds to selection of output of the ALU in the L11. In addition, the output from the ALU in the L12 has been inputted to the DFF3 in the L12.

Thus, selection of input from the DFF3 in the L12 by the MUX in the L13 corresponds to selection of output from the ALU in L12. Thus, the MUX in the each logic circuit can select any one of the output from the ALU in the logic circuit including the MUX, the output from the ALU located on the preceding row, and the output from the ALU in the row above the preceding row, and can output the selected one to the DFF1.

Then, the output from the DFF1 is inputted to the ALUs in the three logic circuits respectively located on the same, right and left columns of the following row. For example, the output from the DFF1 in the L21 is outputted to the ALU in the L12, the ALU in the L22, and the ALU in the L32.

### (Example of a triple precision operation by using the reconfigurable circuit 12B)

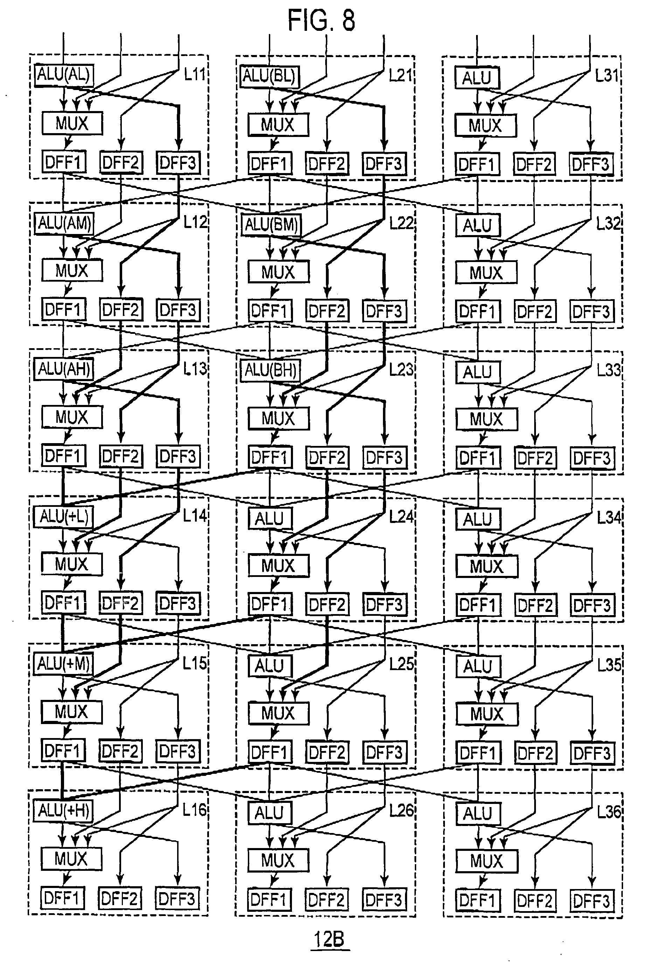

An example of performing a triple precision operation by use of the reconfigurable circuit 12B will be described with reference to Fig. 8.

Here, on the assumption that the operation bit width of an ALU in each logic circuit of the reconfigurable circuit 12B is 16 bits, an explanation will be given for an example in which addition of 48-bits variables A+B is performed. Higher 16 bits of a 48-bits variable A are assumed as AH, medium 16 bits are assumed as AM, and lower 16 bits are assumed as AL, higher 16 bits of a 48-bits variable B are assumed as BH, middle 16 bits are assumed as BM, and lower 16 bits are assumed as BL. In such case, the operation A+B is performed by being divided into addition of the lower-order bits AL+BL, addition of the middle-order bits AM+BM, and addition of the higher-order bits AH+BH.

Here, it is assumed that output from the ALU in the L11 is AL, output from the ALU in the L12, AM; and output from the ALU in the L13, AH; output from the ALU in the L21, BL; output from the ALU in the L22, BM; and output from the ALU in the L23, BH.

First, an operation of lower-order bits will be described. The AL outputted from the ALU in the L11 is inputted to the MUX in the L13 via the DFF3 in L11 and the DFF2 in the L12. In this MUX, this AL is selected, outputted to the DFF1 in the L13, and then outputted to the ALU in the L14 via this DFF1.

Meanwhile, the BL outputted from the ALU in the L21 is inputted to the MUX in the L23 via the DFF3 in the L21 and the DFF2 in the L22. In this MUX, this BL is selected, outputted to the DFF1 in the L23, and then outputted to the ALU in L14 via this DFF1. Subsequently, addition of the AL and the BL is performed in the ALU in the L14.

With the configuration as described above, the adding process of the outputs of the logic circuits L11 and L21 located on the row three rows above can be performed by using the ALU in the L14.

Specifically, the MUX in the L13 located on the preceding row of the same column as L14 including the ALU configured to perform the lower-order bit adding process selects, not the output from the ALU in the same logic circuit L13 including the MUX, but the output from the ALU in the logic circuit L11 in the row above the preceding row of the same column. In addition, the MUX in the L23 located on the preceding row of the right column of the L14 selects, not the output from the ALU in the L23, but the output from the ALU in the L21 located on the row above the preceding row of the same column. Thus, the adding process of the outputs of the logic circuits L11 and L21 arranged three rows above can be performed.

Secondly, an operation of middle-order bits will be described. The AM to be outputted from the ALU in the L12 is inputted to the MUX in the L14 via the DFF3 in the L12 and the DFF2 in the L13. In this MUX, this AM is selected, outputted to the DFF1 in the L14, and then outputted to the ALU in the L15 via this DFF1.

Meanwhile, the BM outputted from the ALU in the L22 is inputted to the MUX in the L24 via the DFF3 in the L22 and the DFF2 in the L23. In this MUX, this BM is selected, outputted to the DFF1 in the L24, and then outputted to the ALU in the L15 via this DFF1. Subsequently, in the ALU in the L15, addition of the AM and the BM is performed.

Specifically, the MUX in the L14 located on the preceding row of the same column as L15 including the ALU configured to perform the middle-order bit adding process selects, not the output from the ALU in the same logic circuit L14 including the MUX, but the output from the ALU in the logic circuit L12 in the row above the preceding row of the same column. In addition, the MUX in the L24 located on the preceding row of the right column of the L15 selects, not the output from the ALU in the L24, but the output from the ALU in the L22 located on the row above the preceding row of the same column. Thus, the adding process of the outputs of the logic circuits L12 and L22 arranged three rows above can be performed.

Thirdly, an operation of higher-order bits will be described. The AH outputted from the ALU in the L13 is inputted to the MUX in the L15 via the DFF3 in the L13 and the DFF2 in the L14. In this MUX, this AH is selected, outputted to the DFF1 in the L15, and then outputted to the ALU in the L16 via this DFF1.

Meanwhile, the BH outputted from the ALU in the L23 is inputted to the MUX in the L25 via the DFF3 in the L23 and the DFF2 in the L24. In this MUX, this BH is selected, outputted to the DFF1 in the L25, and then outputted to the ALU in the L16 via the DFF1. Subsequently, in the ALU in the L16, addition of the AH and the BH is performed.

Specifically, the MUX in the L15 located on the preceding row of the same column as L16 including the ALU configured to perform the higher-order bit adding process selects, not the output from the ALU in the same logic circuit L15 including the MUX, but the output from the ALU in the L13 in the row above the preceding row of the same column. In addition, the MUX in the L25 located on the preceding row of the right column of the L16 selects, not the output from the ALU in the L25, but the output from the ALU in the L23 located on the row above the preceding row of the same column. Thus, the adding process of the outputs of the logic circuits L13 and the L23 located three rows above can be performed.

In this manner, the logic circuits each performing the lower-order bit operation, the middle-order bit operation, and the higher-order bit operation can be serially arranged in a vertical direction, and thus a triple precision operation can be performed.

### (Example of a double precision operation using the reconfigurable circuit 12B)

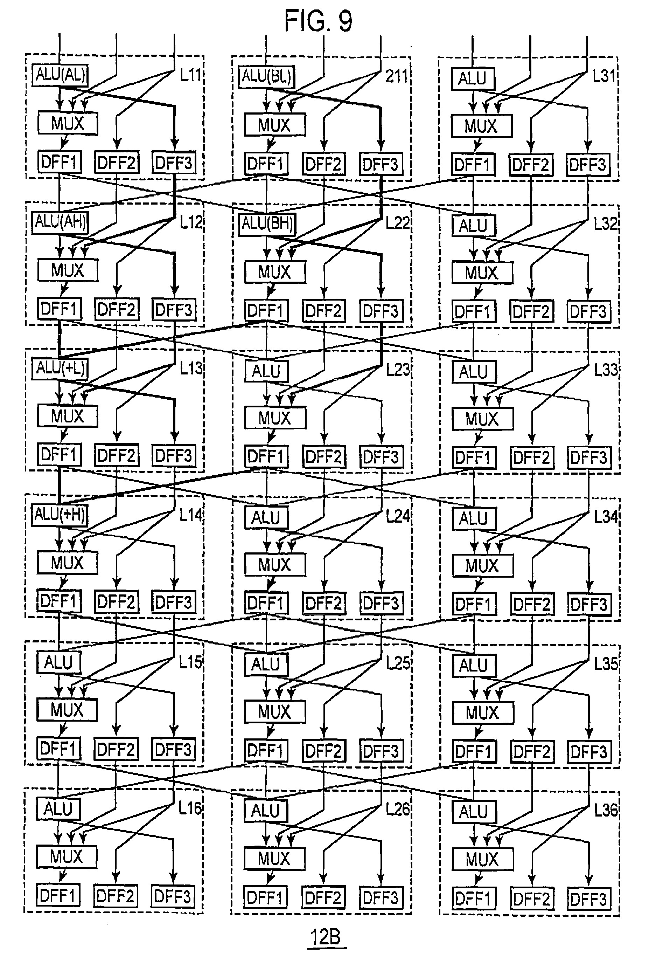

An example of performing a double precision operation by use of the reconfigurable circuit 12B will be described with reference to Fig. 9.

Here, a description will be given for an example in which addition of the 32-bits variables A+B is performed when the operation bit width of an ALU in each logic circuit of the reconfigurable circuit 12B is 16 bits. When it is assumed that higher 16 bits of the 32-bits variable A are AH, lower 16 bits are AL, higher 16 bits of the 32-bits variable B are BH and lower 16 bits are BL, the operation A+B is performed by being divided into addition of lower-order bits AL+BL and addition of higher-order bits AH+BH.

Here, it is assumed that output from the ALU in the L11 is AL, output from the ALU in the L12 is AH, output from the ALU in the L21 is BL, and output from the ALU in the L22 is BH.

First, an operation of lower-order bits will be described. The AL outputted from the ALU in the L11 is inputted to the MUX in the L12 via the DFF3 in the L11. In this MUX, this AL is selected, outputted to the DFF1 in the L12, and then outputted to the ALU in the L13 via this DFF1.

Meanwhile, the BL outputted from the ALU in the L21 is inputted to the MUX in the L22 via the DFF3 in the L21. In this MUX, this BL is selected, outputted to the DFF1 in the L22, and then outputted to the ALU in the L13 via this DFF1. Subsequently, in the ALU in the L13, addition of the AL and the BL is performed.

With the configuration as described above, the adding process of the outputs of the logic circuits L11 and L21 arranged two rows above can be performed by using the ALU in the L13.

Specifically, the MUX in the L12 located on the preceding row of the same column as L13 including the ALU configured to perform the lower-order bit adding process selects, not the output from the ALU in the same logic circuit L12 including the MUX, but the output from the ALU in the logic circuit L11 located on the preceding row of the same column. In addition, the MUX in the L22 located on the preceding row of the right column of the L13 selects, not the output from the ALU in the L22, but the output from the ALU in the L21 located on the preceding row. Thus, the adding process of the outputs of the logic circuits L11 and L21 arranged two rows above can be performed.

Secondly, an operation of higher-order bits will be described. The AH outputted from the ALU in the L12 is inputted to the MUX in the L13 via the DFF3 in the L12. In this MUX, this AH is selected, outputted to the DFF1 in the L13, and then outputted to the ALU in the L14 via this DFF1.

Meanwhile, the BH outputted from the ALU in the L22 is inputted to the MUX in the L23 via the DFF3 in the L22. In this MUX, this BH is selected, outputted to the DFF1 in the L23, and then outputted to the ALU in the L14 via this DFF1. Subsequently, in the ALU in the L14, addition of the AH and the BH is performed.

Specifically, the MUX in the L13 located on the preceding row of the same column as L14 including the ALU configured to perform the higher-order bit adding process selects, not the output from the ALU in the same logic circuit L13 including the MUX, but the output from the ALU in the logic circuit L12 located on the preceding row of the same column. In addition, the MUX in the L23 located on the preceding row of the right column of the L14 selects, not the output from the ALU in the L23, but the output from the ALU in the L22 located on the preceding row. Thus, the adding process of the outputs of the logic circuits L12 and L22 arranged two rows above can be performed.

Thus, the logic circuits each performing the lower-order bit operation and the higher-order bit operation can be serially arranged in a vertical direction, and thus a double precision operation can be also performed.

### (Example of a single precision operation by use of the reconfigurable circuit 12B)

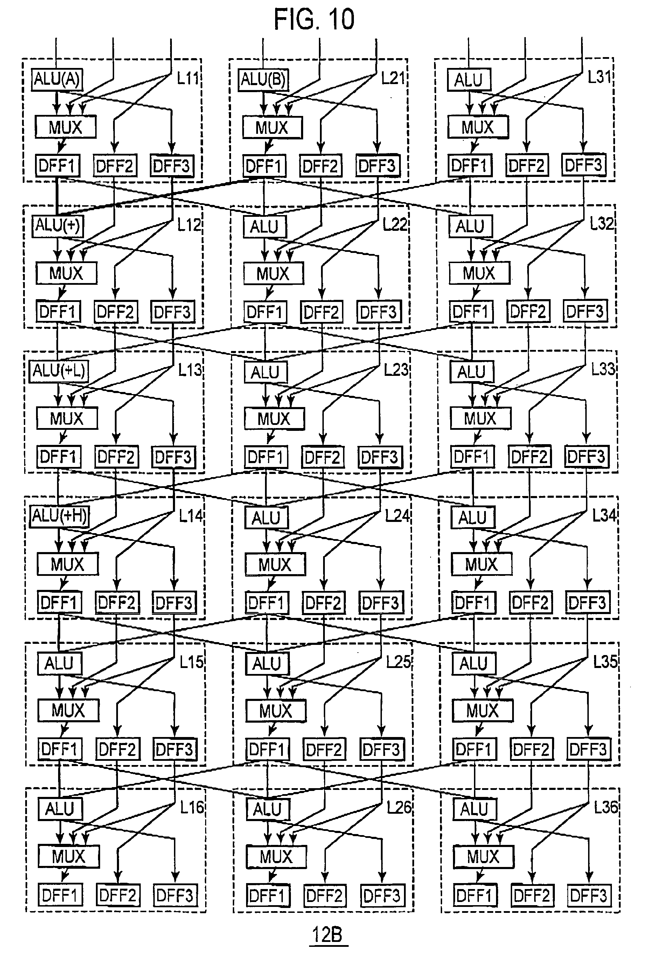

An example of performing a single precision operation by use of the reconfigurable circuit 12B will be described hereinafter with reference to Fig. 10.

Here, a description will be given for an example in which addition of the 16-bits variables A+B is performed when the operation bit width of an ALU in each logic circuit of the reconfigurable circuit 12B is 16 bits. It is assumed that the output from an ALU in L11 is A, and the output from an ALU in L21 is B.

The A outputted from the ALU in the L11 is inputted to an MUX in the L11. In this MUX, this A is selected and outputted to a DFF1 in the L11. Subsequently, the A is outputted to the ALU in the L12 via this DFF1.

Meanwhile, the B outputted from the ALU in L21 is inputted to an MUX in the L21. In this MUX, this B is selected, outputted to DFF1 in the L21, and then outputted to the ALU in the L12 via this DFF1. Subsequently, in the ALU in the L12, addition of the A and the B is performed.

In this manner, single precision addition can be performed by using the ALU in the L12. Specifically, the MUX in the L11 located on the preceding row of the same column of the L12 including the ALU configured to perform the adding process selects the ALU in the same logic circuit L11 including the MUX. In addition, the MUX in the L21 located on the preceding row of the right column of the L12 selects the output from the ALU in the L21. The adding process of single precision can also be performed in the reconfigurable circuit 12B in this manner.

Thus, in the reconfigurable circuit 12B, switching among the triple precision, the double precision, and the single precision operation can be performed by controlling the selection of input to the MUX provided in each logic circuit.

### [Fourth Embodiment]

### (Configuration of a reconfigurable circuit 12C)

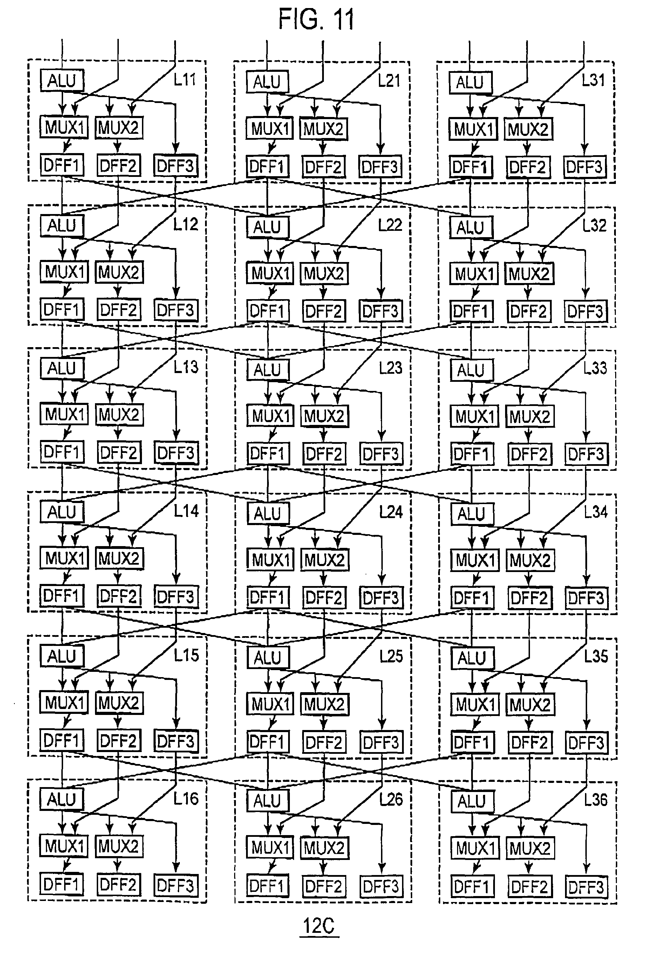

In a reconfigurable circuit 12C as shown in Fig. 11, all of the triple precision, the double precision, and the single precision can be performed. This reconfigurable circuit 12C is formed by arranging logic circuits (designated as an L11,..., L16, L21, ..., L26, and L31,... in Fig. 11) in arrays. Each of the logic circuits includes an ALU that is an operation circuit, an MUX that is a selecting unit, and a DFF1, a DFF2, and a DFF3 that are D-type flip flops.

In each logic circuit, output from the ALU is outputted to the MUX1, the MUX2, and the DFF3.

The MUX1 in each logic circuit selects either output from the ALU in the same logic circuit including the MUX1 or output from the DFF2 located on the preceding row, and outputs the selected one to the DFF1 in the same logic circuit. For example, the MUX in the logic circuit L13 selects either the ALU in the L13 or the DFF2 in the L12, and then outputs the selected one to the DFF1 in the L13.

The MUX2 in each logic circuit selects either output from the ALU in the same logic circuit including the MUX2 or output from the DFF3 located on the preceding row, and outputs the selected one to the DFF2 in the same logic circuit. For example, the MUX2 in the logic circuit L13 selects output from either the ALU in the L13 or the DFF3 in the L12, and outputs the selected one to the DFF2 in the L13.

In addition, the output from the DFF3 is outputted to the MUX2 in the following row.

### (Example of a triple precision operation by use of the reconfigurable circuit 12C)

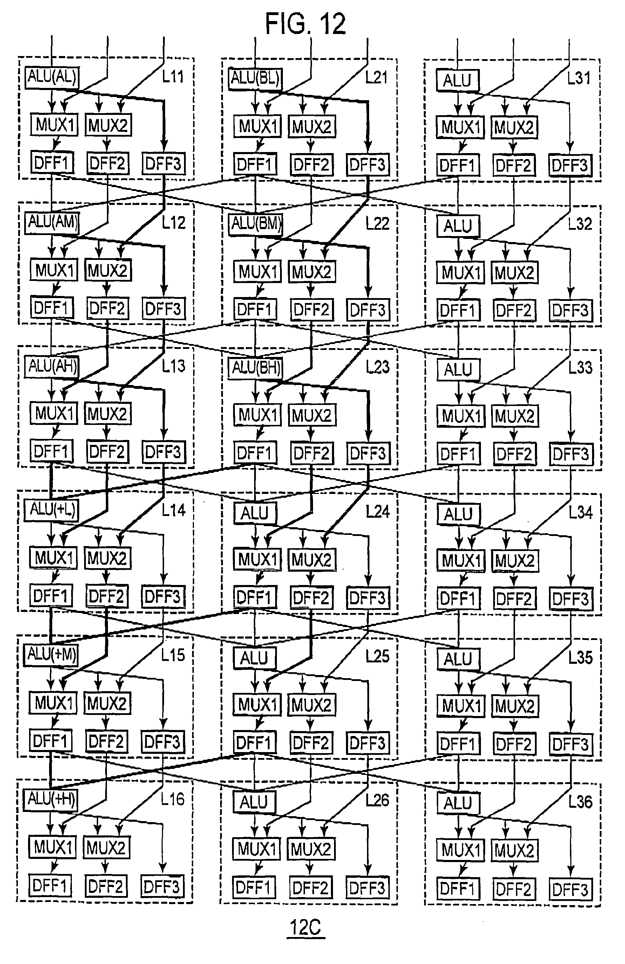

An example of performing a triple precision operation by use of the reconfigurable circuit 12C will be described with reference to Fig. 12.

Here, on the assumption that the operation bit width of the ALU in each logic circuit of the reconfigurable circuit 12C is 16 bits, an example in which 48-bits variables A+B is added is described. Here, assume that higher 16 bits of the 48 bit variable A are AH, middle 16 bits are AM, and lower 16 bits are AL, higher 16 bits of B are BH, middle 16 bits are BM, and lower 16 bits are BL. Moreover, outputs from the ALUs in the L11, the L12, and the L13 are AL, AM, and AH, respectively, while outputs from the L21, the L22, and the L23 are BL, BM, and BH, respectively.

First, an operation of lower-order bits will be described. The AL outputted from the ALU in the L11 is outputted to the ALU in the L14 via the DFF3 in the L11, the MUX2 and the DFF2 in the L12, and the MUX1 and the DFF1 in the L13.

Meanwhile, the BL outputted from the ALU in the L21 is outputted to the ALU in L14 via the DFF3 in the L21, the MUX2 and the DFF2 in the L22, and the MUX1 and the DFF1 in the L23. Subsequently, in the ALU in the L14, addition of the AL and the BL is performed.

Secondly, an operation of middle-order bits will be described. The AM outputted from the ALU in the L12 is outputted to the ALU in the L15 via the DFF3 in the L12, the MUX2 and the DFF2 in the L13, and the MUX1 and the DFF1 in the L14.

Meanwhile, the BM outputted from the ALU in the L22 is outputted to the ALU in the L15 via the DFF3 in the L22, the MUX2 and the DFF2 in the L23, and the MUX1 and the DFF1 in the L24. Subsequently, in the ALU in the L15, addition of the AM and the BM is performed.

Thirdly, an operation of higher-order bits will be described. The AH outputted from the ALU in the L13 is outputted to the ALU in the L16 via the DFF3 in the L13, the MUX2 and the DFF2 in the L14, and the MUX1 and the DFF1 in the L15.

Meanwhile, the BH outputted from the ALU in the L23 is outputted to the ALU in the L16 via the DFF3 in the L23, the MUX2 and the DFF2 in the L24, and the MUX1 and the DFF1 in the L25. Subsequently, in the ALU in the L16, addition of the AH and the BH is performed.

Thus, the logic circuits each performing the lower-order bit operation, the middle-order bit operation, and the higher-order bit operation can be serially arranged in a vertical direction, and thus a triple precision operation can be performed.

### (Example of a double precision operation by use of the reconfigurable circuit 12C)

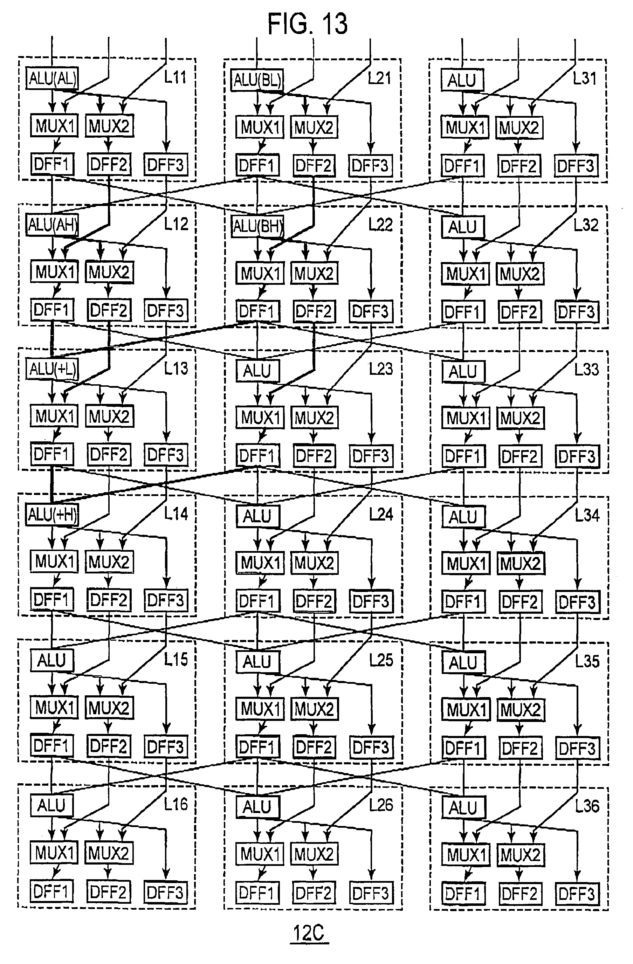

An example of performing a double precision operation by use of the reconfigurable circuit 12C will be described with reference to Fig. 13.

Here, a description will be given for an example in which the addition of 32-bits variables A+B is performed when the operation bit width of the ALU in each logic circuit of the reconfigurable circuit 12C is 16 bits. Here, it is assumed that higher 16 bits of the 32-bits variable A are AH, and lower 16 bits are AL, higher 16 bits of the 32-bits variable B are BH and lower 16 bits are BL. Moreover, it is assumed that the outputs from the ALUs in the L11 and the L12 are AL and AH, respectively, and the outputs from the ALUs in the L21 and the L22 are BL and BH, respectively.

First, an operation of lower-order bits will be described. The AL outputted from the ALU in the L11 is outputted to the ALU in L13 via the MUX2 and the DFF2 in the L11, and the MUX1 and the DFF1 in the L12. Meanwhile, the BL outputted from the ALU in the L21 is outputted to the ALU in L13 via the MUX2 and the DFF2 in L21, and the MUX1 and the DFF1 in the L22. Subsequently, in the ALU in the L13, addition of the AL and the BL is performed.

Secondly, an operation of higher-order bits will be described. The AH outputted from the ALU in the L12 is outputted to the ALU in the L14 via the MUX2 and the DFF2 in the L12, and the MUX1 and the DFF1 in the L13. Meanwhile, the BH outputted from the ALU in the L22 is outputted to the ALU in the L14 via the MUX2 and the DFF2 in the L22, and the MUX1 and the DFF1 in the L23. Subsequently, in the ALU in the L14, addition of the AH and the BH is performed.

In this manner, the logic circuits each performing the lower-order bit operation and the higher-order bit operation can be serially arranged in a vertical direction, and thus a double precision operation can be also performed.

### (Example of a single precision operation by use of the reconfigurable circuit 12C)

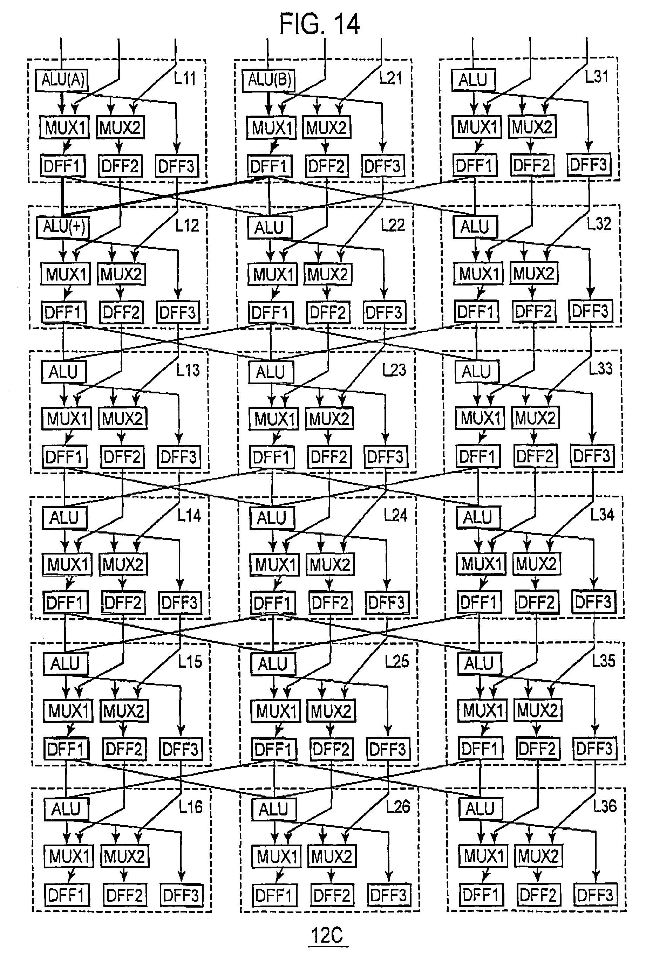

An example of performing a single precision operation by use of the reconfigurable circuit 12C will be described with reference to Fig. 14.

Here, a description will be given for an example in which the addition of 16-bits variables A+B is performed when the operation bit width of the ALU in each logic circuit of the reconfigurable circuit 12C is 16 bits. Output from the ALU in the L11 is A, while output from the ALU in the L21 is B.

The A outputted from the ALU in the L11 is outputted to the ALU in the L12 via the MUX1 and the DFF1 in the L11. Meanwhile, the B outputted from the ALU in the L21 is outputted to the ALU in the L12 via the MUX1 and the DFF1 in the L21. Subsequently, in the ALU in the L12, addition A+B is performed. This enables the adding process of single precision.

Thus, in the reconfigurable circuit 12C, switching among the triple precision, the double precision operation, and the single precision operation can be performed by controlling the selecting units MUX1 and MUX2 provided in the each logic circuits.

### [Fifth Embodiment]

### (Configuration of a reconfigurable circuit 12D)

The present embodiment relates to a reconfigurable circuit 12D capable of both a double precision shift operation and a single precision shift operation.

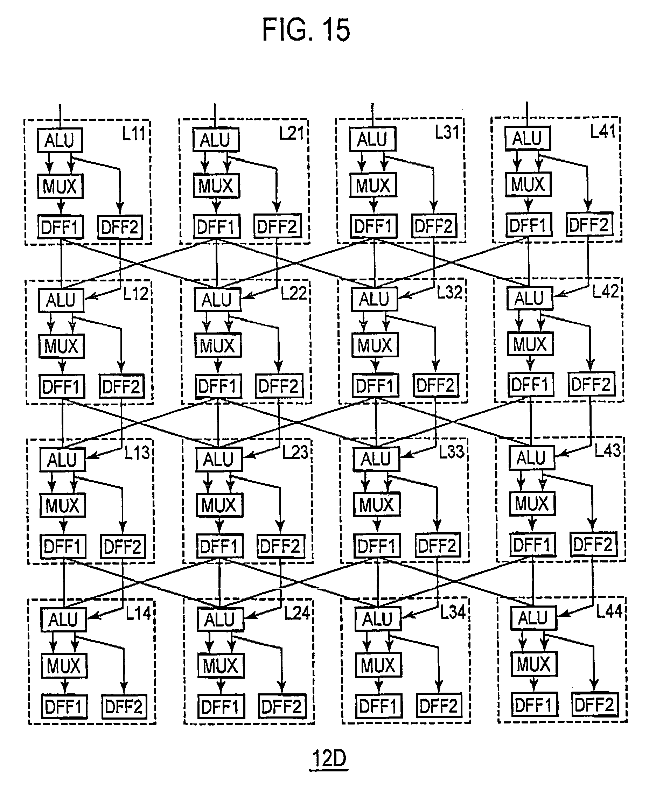

With reference to Fig. 15, the reconfigurable circuit 12D is formed by arranging logic circuits (designated as L11,...,L44 in Fig. 15) in arrays. Each of the logic circuits includes the ALU that is an operation circuit functioning as a barrel shifter, an MUX that is a selecting unit, and a DFF1 and a DFF2 that are D-type flip flops.

In each logic circuit, the ALU has two outputs. A first output is outputted to the MUX. A second output is outputted to both the MUX and the DFF2. Detailed description for the first output and the second output will be given later.

The MUX in each logic circuit selects either the first output or the second output, and then outputs the selected one to DFF1.

The output from the DFF1 is outputted to (the ALU of) the logic circuit in the following row (located on the same, the right or left column). Meanwhile, the output from the DFF2 is outputted to (the ALU of) the logic circuit in the following row of the same column. (Configuration of an ALU in a logic circuit in the reconfigurable circuit 12D)

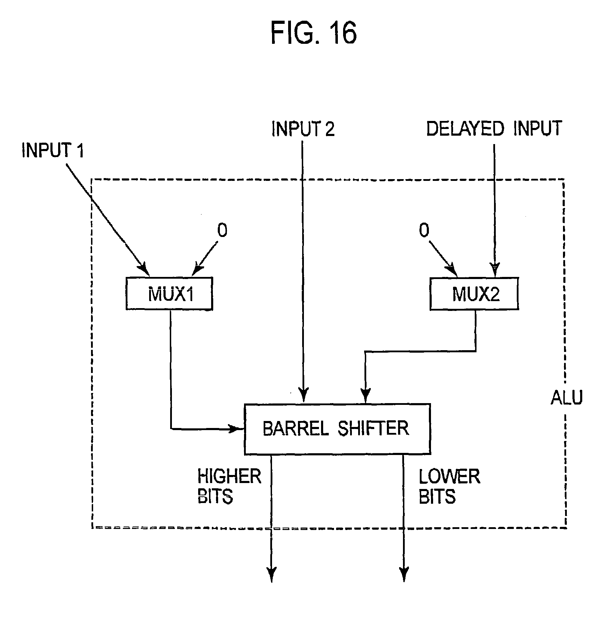

Fig. 16 is a view showing a configuration of the ALU in the logic circuit included in the reconfigurable circuit 12D. This ALU includes a barrel shifter, and an MUX1 and MUX2 that are selecting units. Each ALU receives three inputs of an input 1, an input 2, and a delayed input. The input 1 and the input 2 correspond to data outputted from a DFF1 of any logic circuit located on the preceding row. The delayed input corresponds to data outputted from a DFF2 of a logic circuit located on the preceding row of the same column. Note that the input 1, the input 2, and the delayed input each are 16-bits data, and the barrel shifter is capable of shift operations for 32-bits data. In addition, each MUX can handle 16-bits data.

The MUX 1 selects either the input 1 or 0 (zero), and then outputs the selected one to the barrel shifter. The MUX2 selects either the delayed input or 0 (zero), and then outputs the selected one to the barrel shifter.

The barrel shifter receives three inputs of 16-bits data of output from the MUX1, output from the MUX2, and the input 2. The barrel shifter performs a shift operation on 32-bits data so as to shift bit data by the number of bits specified by the MUX1. The 32-bits data here is obtained by combining the data from the MUX2 as lower 16 bits and the data from the input 2 as higher 16 bits. Subsequently, out of the 32-bits data that has been subjected to the shift operation, the higher 16 bits are outputted to the MUX and the DFF2, while the lower 16 bits are outputted to the MUX.

### (Example of a double precision operation by use of the reconfigurable circuit 12D)

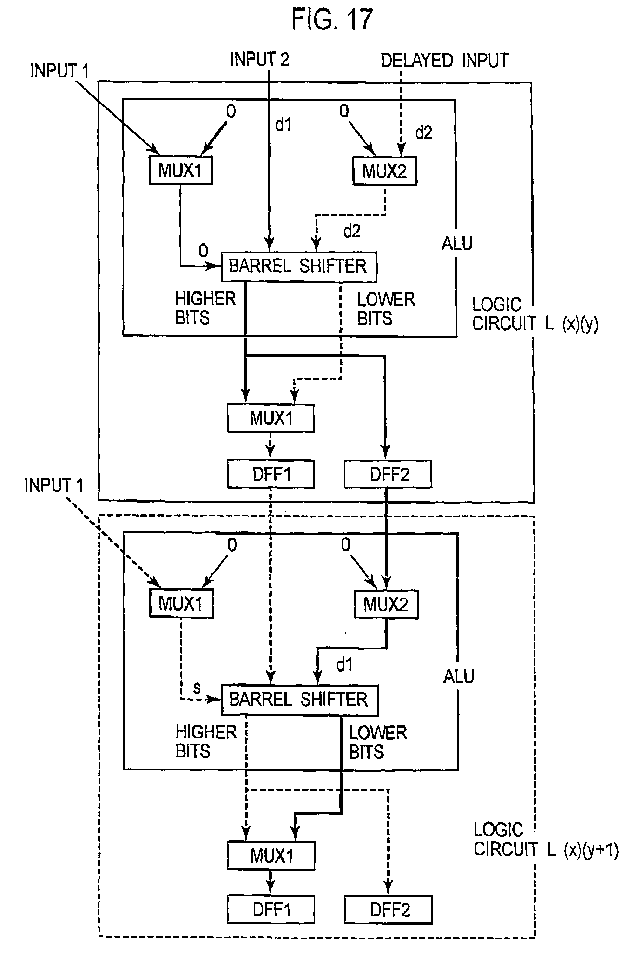

An example of performing a double precision operation by use of the reconfigurable circuit 12D will be described with reference to Fig. 17. Here, an explanation will be given for an example in which a double precision bit shift operation is performed on data consisted of higher 16 bits d2 and lower 16 bits d1. Here, the double precision bit shift operation is performed by use of the logic circuits L(x) (y) and L (x) (y+1) that is arranged adjacent to each other in a column direction.

First, the MUX2 in the L(x)(y) selects the data d2 being the delayed input. Subsequently, data in which the data d1 being the input 2 and the data d2 are combined is inputted to the barrel shifter. In other words, 32-bits data consisted of the data d1 as higher 16 bits and the data d2 as lower 16 bits is inputted to the barrel shifter.

Meanwhile, the MUX1 in the L(x) (y) selects 0 and outputs the 0 to the barrel shifter. Thus, the barrel shifter outputs the higher 16 bits (i.e., d1) to the DFF2 and MUX without performing the shirt operation. Further, the barrel shifter outputs the lower 16 bits (i.e., d2) to the MUX. The MUX selects the lower 16 bits (data d2) and then outputs the lower 16 bits d2 to the DFF1.

Secondly, MUX2 in the L (x) (y+1) selects the delayed input (data d1). Subsequently, 32-bits data consisted of the input 2 (data d2) as the higher 16 bits and the data d1 as the lower 16 bits is inputted to the barrel shifter.

Meanwhile, the MUX1 in the L(x)(y+1) selects data s that is the input 1, and outputs the data s to the barrel shifter. Then, the barrel shifter shifts the foregoing 32-bits data (to the right herein) by s bits. Then, the higher 16 bits of the 32-bits data that has been shifted by s bits is outputted from the barrel shifter to the DFF2 and the MUX, and the lower 16 bits is outputted from the barrel shifter to the MUX.

In this manner, a double precision barrel shift operation can be performed by use of the reconfigurable circuit 12D.

### (Example of a single precision operation by use of the reconfigurable circuit 12D)

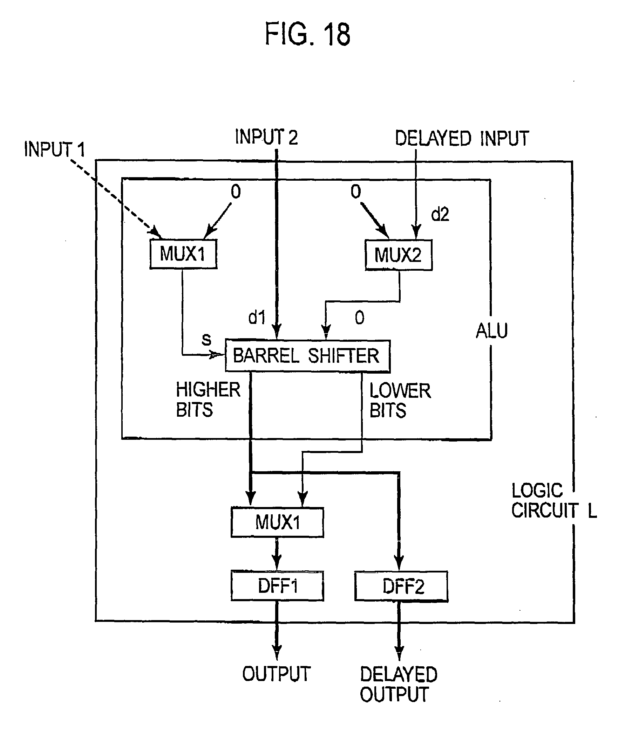

An example of performing a single precision operation by use of the reconfigurable circuit 12D will be described with reference to Fig. 18. Here, an explanation will be given for an example in which a single precision barrel shift operation is performed on the data d1.

First, the MUX 2 selects 0. Here, this 0 is not the delayed input. Then, 32-bit-format data consisted of the input 2 (data d1) as higher 16 bits and 0 as lower 16 bits is inputted to the barrel shifter.

Meanwhile, the MUX1 selects the input 1 (data s) and then outputs the input 1 to the barrel shifter. Thus, the barrel shifter shifts the foregoing 32-bit-format data (to the right herein) by s bits. Then, the higher 16 bits of the 32 bits data that has been shifted by s bits is outputted from the barrel shifter to the DFF2 and the MUX, and the lower 16 bits is outputted from the barrel shifter to the MUX. The MUX selects the higher 16 bits from the higher-order and the lower-order bits, and then outputs the selected higher 16 bits to the DFF1. Note that, the output from the DFF1 is inputted to a logic circuit in any one of the same, right or left columns in the following row. In other words, the data obtained by shifting the data d1 by s bits is outputted to the logic circuit in the following row.

According to this reconfigurable circuit 12D, a barrel shift operation of single precision can be performed. In addition, the MUX2 selects 0 and thereby 0 is inputted to the lower 16 bits of the barrel shifter, so that the single precision barrel shift operation can be properly performed not only in a right shift operation but also in a left shift operation.

According to the reconfigurable circuit 12D, one barrel shifter of double precision can perform shift operations of both single precision and double precision. Therefore, the circuit size can be reduced, compared with the one including two barrel shifters of single precision and double precision.

Note that, in the reconfigurable circuit 12D as described above, the input 1 and the input 2 are data outputted from the DFF1 of the logic circuit located on the preceding row. However, inputs are not limited to the foregoings. For example, a constant may merely be inputted, or data inputted from an unillustrated state holding circuit (such as a RAM) provided in the reconfigurable circuit may be inputted.

### [Sixth Embodiment]

### (Configurable of a reconfigurable circuit 12E)

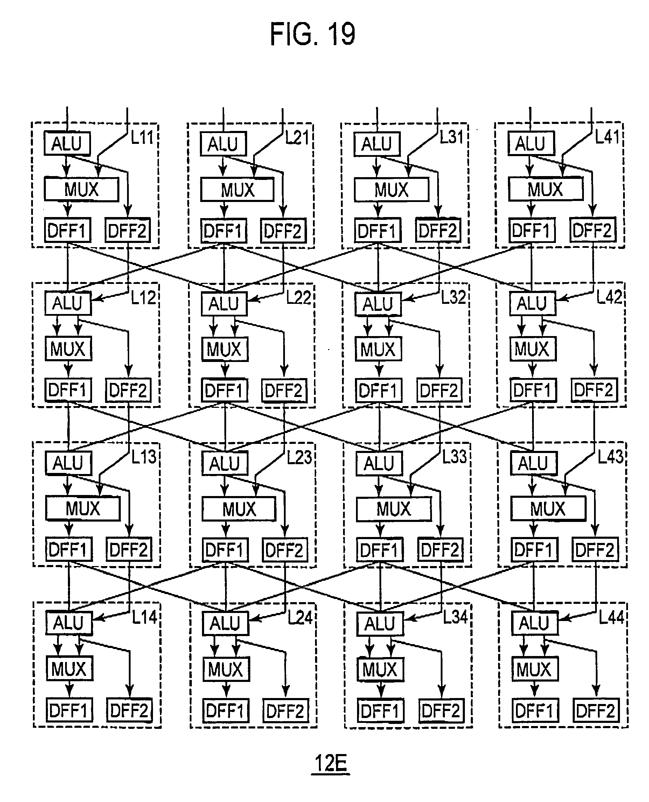

A reconfigurable circuit 12E as shown in Fig. 19 can also perform barrel shift operations. Compared with the reconfigurable circuit 12D, the reconfigurable circuit 12E has different configurations of the logic circuits (L11, L21, L31, L41, L13, L23, L33 and L43) in odd-numbered rows. In this reconfigurable circuit 12E, barrel shift operations of double precision can be performed by using two logic circuits as a pair consisted of the logic circuit L(x)(2y-1) in the odd-numbered row and the logic circuit L(x)(2y) in the even-numbered row.

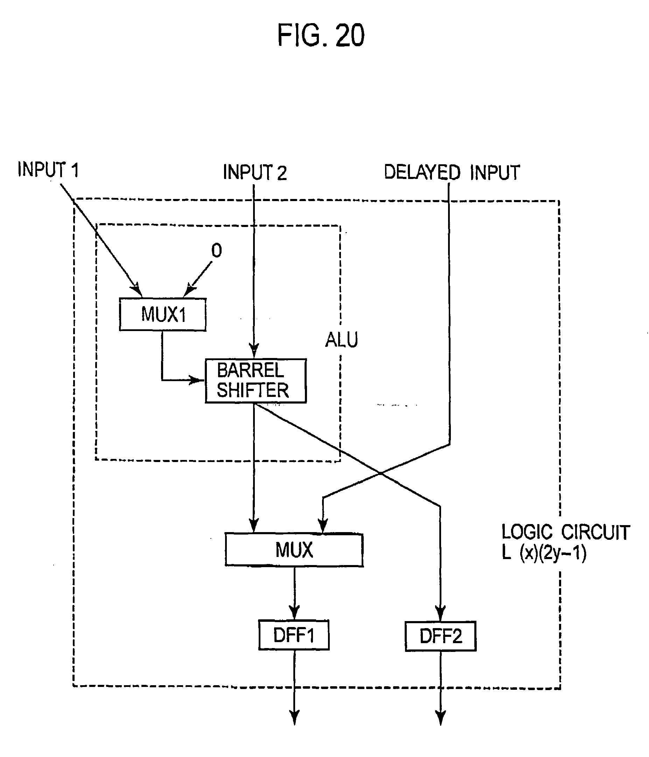

Fig. 20 is a view showing a configuration of the logic circuit of the L(x)(2y-1) arranged in the odd-numbered rows of the reconfigurable circuit 12E. This logic circuit L(x)(2y-1) differs from the ALU in the reconfigurable circuit 12D in that the ALU does not include the selecting unit MUX2 and that the barrel shifter corresponds to 32-bits data but 16-bits data. Note that the configuration in each logic circuit L(x)(2y) arranged in the even-numbered rows of the reconfigurable circuit 12E is same as that of the ALU in each logic circuit of the reconfigurable circuit 12D.

### (Example of a double precision operation by use of the reconfigurable circuit 12E)

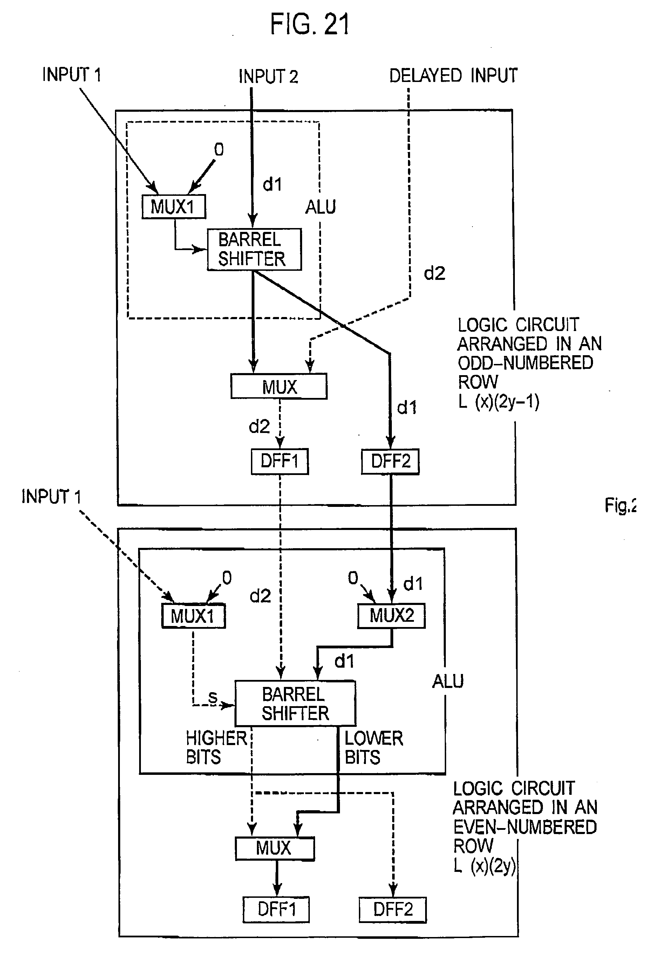

An example of performing a double precision operation by use of the reconfigurable circuit 12E will be described with reference to Fig. 21. Here, description will be given for an example in which a double precision bit shift operation is performed on 32-bits data consisted of higher 16 bits as d2 and lower 16 bits as d1, by use of logic circuits L (x) (2y-1) and L(x)(2y) in the following row of the same column.

First, an operation in the L(x)(2y-1), which is the logic circuit arranged in the even-numbered row, will be described. The data d1 that has been inputted to the L(x)(2y-1) as the input 2 is inputted to the barrel shifter of the L(x)(2y-1). The MUX1 in the ALU selects 0, not the input 1, and then outputs the 0 to the barrel shifter. Thus, the barrel shifter outputs the data d1 to both the MUX and the DFF2, without changing the data (without performing bit shift).

Meanwhile, the output from the barrel shifter mentioned above and the data d2 that has been inputted to the L(x)(2y-1) as delayed input are inputted to the MUX. The MUX selects the data d2 from them and then outputs the data d2 to the DFF1. The d2 outputted from the DFF1 is outputted to the L(x)(2y). The d1 outputted from the DFF2 is outputted to the L(x) (2y) as the delayed output.

Secondly, an operation in the L(x)(2y), which is the logic circuit arranged in the even-numbered row, will be described. The data s that has been inputted to the L (x) (2y) as the input 1, and 0 are inputted to the MUX1 in the L(x)(2y). The MUX1 selects the data s and then outputs the data s to the barrel shifter. The MUX2 selects the data d1 from the delayed input (d1 being the delayed output mentioned above) and 0, and then outputs the data d1 to the barrel shifter. The barrel shifter receives 32-bits data consisted of the input 2 (d2 mentioned above) as higher 16 bits and the data d1 as lower 16 bits.

Then, the barrel shifter outputs to the DFF2 and the MUX the higher 16 bits of the data obtained by shifting this 32-bits data by s bits, and the lower 16 bits to the MUX. In this manner, the reconfigurable circuit 12E can also perform the double precision barrel shift operations.

In other words, while the reconfigurable circuit 12D performs a double precision shift operation by using a logic circuit in any row and a logic circuit in the following row of the same column, the reconfigurable circuit 12E performs a double precision shift operation by using two logic circuits respectively in an odd-numbered row and an even-number row following the odd-numbered row. Here, "any row" is limited to an odd-numbered row and "row following the odd-numbered row" is limited to an even-numbered row. Therefore, a barrel shifter in a logic circuit arranged in an odd-numbered row can performed single precision (not 32 bits but 16 bits in this example). Thus, a size reduction of the circuit can be realized.

### [Seventh Embodiment]

### (Configuration of a reconfigurable circuit 12F)

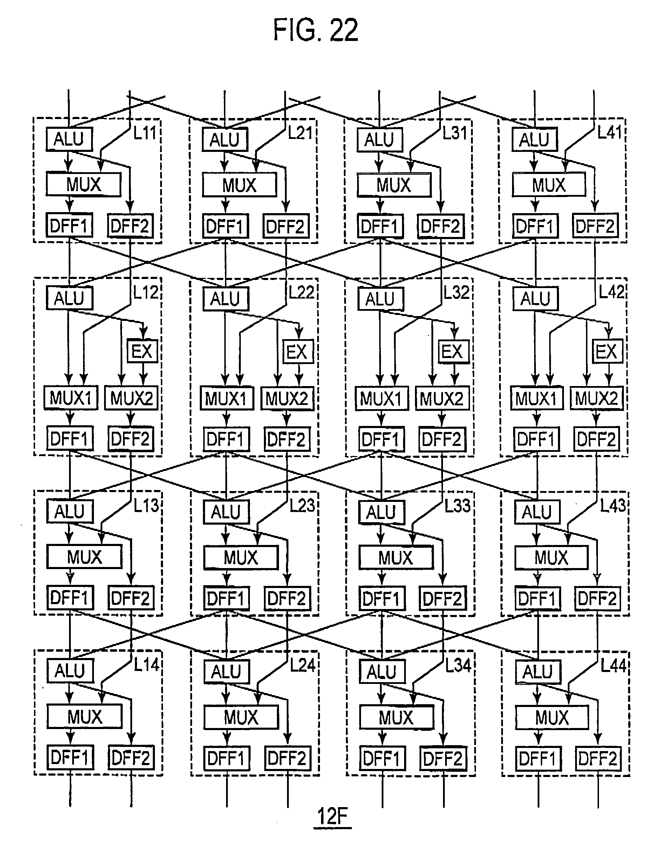

Fig. 22 shows a configuration of a reconfigurable circuit 12F that can not only perform both a single precision operation and a double precision operation, but also supply a result of the single precision operation to the double precision operation. This reconfigurable circuit 12F has the operation bit width of 16 bits.

This reconfigurable circuit 12F is different in logic circuits (L12,..., and L42) in the second row. These logic circuits each include an ALU that is an operation circuit, an MUX1 and an MUX2 that are selecting units, a DFF1 and a DFF2 that are D-type flip flops, and an EX that performs a sign extension processing. Here, the sign extension processing indicates a process of generating higher 16 bits after extending originally being a 16-bits variable to 32-bits data. Outputs from the ALU are inputted to an MUX1, and MUX2, and the EX. Output from the EX is outputted to the MUX2. In addition, output from a DFF2 located on the preceding row of the same column is also outputted to the MUX1. When the ALU performs a single precision operation, the MUX2 selects and outputs the EX to the DFF2. Thereby, the DFF2 outputs higher-order bits for an extended variable. In addition, if the MUX1 selects input data from the ALU, the DFF1 outputs the lower-order bits for the extended variable. As described above, in each logic circuit in the second row, a single precision operation is performed; sign extension is performed to convert single precision data into double precision data; then the double precision data is divided and outputted as higher-order and lower-order bits. For example, when an operation result of a single precision operation by the ALU is 0x89ab in terms of the 16-bits variable, output from the EX is 0xffff. Thus, this logic circuit outputs the 32-bitsvariable being 0xffff89ab.

Note that configurations of logic circuits in the first, third, and fourth rows are same as the reconfigurable circuit 12.

### (Examples of operations by use of the reconfigurable circuit 12F)

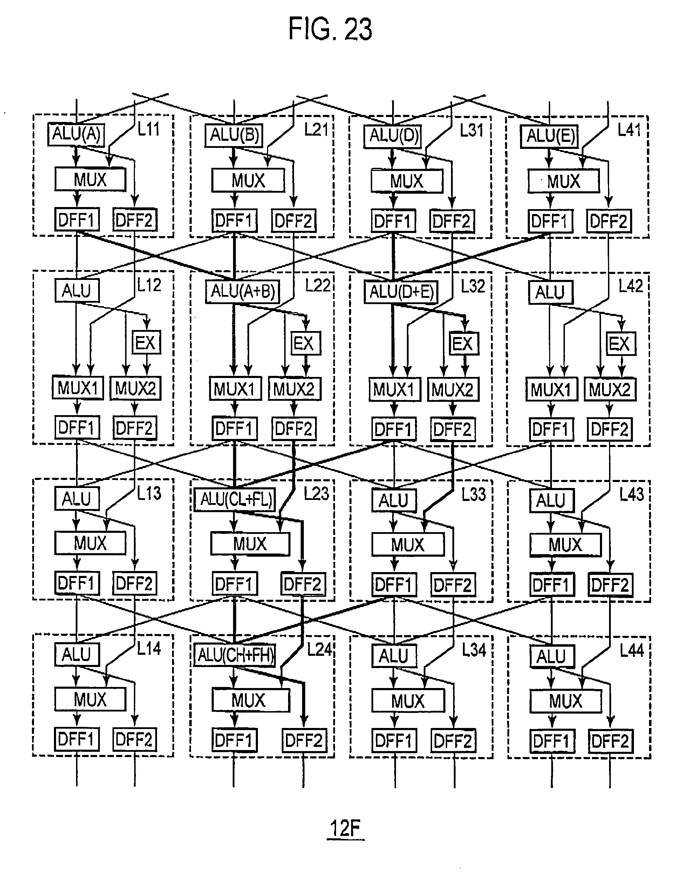

An example of operations by use of the reconfigurable circuit 12F will be described with reference to Fig. 23. Here, description will be given for an example in which a double precision addition C+F is performed after a single precision addition A+B (=C) and a single precision addition D+E (=F) are performed. The operation bit width of each logic circuit of the reconfigurable circuit 12F is 16 bits, and variables A, B, D, and E are also 16-bits variables.

First, the ALUs in logic circuits L11, L21, L31 and L41 output variables A, B, D, and E, respectively.

An MUX in the L11 selects the A, and then the A is inputted to the ALU in the L22 via a DFF1. An MUX in the L21 selects the B, and then the B is also inputted to the ALU in the L22 via the DFF1. Subsequently, in the ALU in the L22, single precision addition A+B is performed.

An MUX in the L31 selects the D, and then the D is inputted to the ALU in the L32 via the DFF1. An MUX in the L41 selects the E, and then the E is also inputted to the ALU in the L32 via the DFF1. Subsequently, in the ALU in the L32, single precision addition of D+E is performed.

The C (=A+B) that is output from the ALU in the L22 is outputted to the MUX1, MUX2, and the EX. The MUX1 selects (not input from a DFF2 in the L21 but) the C that is output from the ALU, and outputs the C to the DFF1. The MUX2 selects output from the EX, and then outputs the output from the EX to the DFF2. Consequently, the DFF2 outputs a CH that is higher 16 bits obtained as a result of sign extension of the 16-bits variable C into a 32-bits variable, while the DFF1 outputs a CL that is lower 16 bits obtained as a result of sign extension of the 16-bits variable C into the 32-bits variable. The CL outputted from the DFF1 is inputted to the ALU in the L23, while the CH outputted from the DFF2 is inputted to the ALU in the L24 via the MUX in the L23.

Similarly, an F (=D+E) , which is the output from the ALU in L32, is outputted to an MUX1, an MUX2, and EX in the L32. The MUX1 selects (not input from a DFF2 in L31 but) the F that is the output from the ALU, and then outputs the F to the DFF1. The MUX2 selects output from the EX, and then outputs the EX to the DFF2. Consequently, the DFF2 outputs an FH that is higher 16 bits obtained as a result of sign extension of the 16-bits variable F into a 32-bits variable, while the DFF1 outputs an FL that is lower 16 bits obtained as a result of sign extension of the 16-bits variable F into the 32-bits variable. The FL outputted from the DFF1 is inputted to the ALU in the L23, while the FH outputted from the DFF2 is inputted to the ALU in the L24 via an MUX in L33.

Consequently, the adding process CL+FL is performed in the ALU in the L23, while the adding process CH+FH is performed in the ALU in the L24. In this manner, the reconfigurable circuit 12F supplies the operation result of the single precision operation to the double precision operation.

Note that, when a double precision operation is performed in an ALU in a logic circuit (L12,..., and L42) in the second row, the MUX 2 selects not input from the EX, but input from the ALU. The operation at this time is the same as that of the reconfigurable circuit 12 that has been described with reference to Fig. 2.

It should be considered that the embodiments disclosed herein are exemplary in all respects and not restrictive at all. It is intended that the scope of the present invention is indicated by not the above description of the embodiments but claims, and that any change that has equivalent meaning as and fall within the claims are included.

For example, although the reconfigurable circuit 12 or the like in the above embodiments is configured so that the output from the DFF1 in each logic circuit is inputted to one of some limited logic circuits in the following row (in the following row of the same, right or left column), the present invention is not limited to this and may be applied to a reconfigurable having different configuration.

Additionally, in the present invention, the description has been given with reference to the above embodiments, taking an example of the reconfigurable circuits formed of logic circuits configured in the row and column directions in a matrix, such as the reconfigurable circuits 12, 12B, and 12C. However, a reconfigurable circuit is not limited to this and may be formed of logic circuits configured in the row direction. In such case, the operation input to each logic circuit may be outputted from a DFF1 of a logic circuit located on the preceding row, inputted from the outside of the reconfigurable circuit, or inputted from a state holding circuit provided in the reconfigurable circuit.

In addition, the reconfigurable circuit may be formed by one logic circuit. Similar to the reconfigurable circuit 12A, set data is supplied from the setting unit 14 to this reconfigurable circuit periodically in a predetermined time (in accordance with a clock cyclically inputted from the controlling unit 18, for example). Then, the logic circuits constituting the reconfigurable circuit operate in accordance with the set data supplied from this setting unit 14. Output from the DFF1 in each logic circuit is looped back to the logic circuit itself as operation input for being used in operation at a next clock. Here, the operation input includes, in addition to the input looped back and inputted from the DFF1 in the logic circuit, input from the outside of the reconfigurable circuit, and the input from the state holding circuit provided in the reconfigurable circuit.

## Claims

1. A processing circuit, comprising a plurality of logic circuits and configured to input an operation output from a first logic circuit into a second logic circuit, wherein
the second logic circuit includes:
an operation circuit configured to perform an operation on inputted data; and
a selecting unit configured to select and output any one of an operation output from the operation circuit or an operation output from the first logic circuit.

2. The processing circuit according to claim 1, wherein
the selecting unit selects and outputs the operation output from the operation circuit, when the second logic circuit performs a single precision operation, and
the selecting unit selects and outputs the operation output from the first logic circuit, when the second logic circuit performs a multiple precision operation.

3. The processing circuit according to claim 1 or 2, wherein the plurality of logic circuits is arranged in a matrix, in a row direction and in a column direction.

4. The processing circuit according to claim 3, wherein the operation output from the selecting unit is inputted into a part of following logic circuits located on a row following the second logic circuit.

5. The processing circuit according to claim 3 or 4, wherein
each of the plurality of logic circuits comprises at least:
a first type logic circuit arranged in a predetermined row and configured to perform a single precision operation or an operation of lower-order digits in a multiple precision operation, and
a second type logic circuit arranged in a row following the predetermined row, and configured to perform an operation of the single precision operation or an operation of higher-order digits in the multiple precision operation.

6. A processing circuit, comprising a plurality of logic circuits arranged in a column direction and configured to operate in accordance with set data supplied periodically in a predetermined time from an outside, wherein
each of the plurality of logic circuits includes:
an operation circuit configured to perform an operation on inputted data;
a state holding circuit configured to store an operation output from the operation circuit for the predetermined time; and
a selecting unit configured to select any one of an operation output from the operation circuit and the operation output held in the state holding circuit, and
the processing circuit further includes a connecting unit configured to input an output from the selecting unit into a part of the plurality of logic circuits.

7. A processing circuit, comprising a logic circuit configured to operate in accordance with set data supplied periodically in a predetermined time from an outside, wherein
the logic circuit includes:
an operation circuit configured to perform an operation on inputted data;
a state holding circuit configured to hold an operation output from the operation circuit for the predetermined time; and
a selecting unit configured to select any one of an operation output from the operation circuit and the operation output held in the state holding circuit, and
the processing circuit further includes a connecting unit configured to input an output from the selecting unit into the logic circuit.
